# EUROPEAN PATENT APPLICATION

(11) **EP 3 496 116 A1**
(43) Date of publication of application: **12.06.2019**
(21) Application number: 17206005.5
(22) Date of filing: 07.12.2017
(51) Int. Cl.: H01F 6/06, H01F 6/00, H01F 6/02, H01L 39/16, H02H 9/02

(54) **APPARATUS AND METHOD FOR CURRENT CONDITIONING, USING A PRIMARY COIL COUPLED TO SECONDARY COILS OF SUPERCONDUCTING MATERIAL, WITH SMOOTHED TRANSITIONS**

(71) Applicant: Bruker HTS GmbH, 63450 Hanau (DE)
(72) Inventor: Usoskin, Alexander, 63456 Hanau (DE)
(74) Representative: Kohler Schmid Möbus Patentanwälte

(57) **Abstract**

An apparatus (1) for current conditioning, comprising
- a primary coil (2) of electrically conducting material, and
- a plurality of secondary coils (3, 3a-3l) of superconductor material, with the secondary coils (3, 3a-3l) inductively coupled to the primary coil (2),
wherein at least a part of the secondary coils (3, 3a-3l) are arranged laterally shifted to each other with respect to a direction (18) of a primary magnetic flux (20) of the primary coil (2), is characterized in
that at least a part of the secondary coils (3, 3a-3l) are arranged axially shifted to each other with respect to a direction (18) of a primary magnetic flux (20) of the primary coil (2),
and that at least for said part of the secondary coils (3, 3a-3l) that are laterally shifted to each other, electrically insulating material (5) is provided between the secondary coils (3, 3a-3l). The invention presents an apparatus for current conditioning which allows a smoother increase of the inductance of the primary coil when the primary current increases.

## Description

The invention relates to an apparatus for current conditioning, comprising
- a primary coil of electrically conducting material, and
- a plurality of secondary coils of superconductor material, with the secondary coils inductively coupled to the primary coil,
wherein at least a part of the secondary coils are arranged laterally shifted to each other with respect to a direction of a primary magnetic flux of the primary coil.

Such an apparatus is known from EP 2 672 537 B1.

Superconducting materials can carry electric currents at practically no ohmic resistance, what may be used to transport electric currents at no loss. Coils made of superconductor material may generate very high magnetic field strengths. Further, superconducting coils squeeze out external magnetic fields from their interior. However, superconductivity gets lost when the electric current to be transported or the magnetic field or the temperature becomes too high. The sudden loss of superconductivity is often called a "quench".

The above effects may be used to build an apparatus for current conditioning, which inductively limits an electric current, for example in order to protect power network from overload, as described in DE 10 2010 007 087 A1. In a choking coil (or primary coil), which carries the current to be limited, a superconducting coil (or secondary coil) is arranged. As long as the secondary coil remains superconductive, the inductance of the primary coil is low, since the secondary coil squeezes out the magnetic flux of the primary coil ("primary flux"). However, if the current in the primary coil becomes too high, the induced current in the secondary coil necessary to squeeze out the primary flux exceeds the critical current, and the secondary coil quenches. Then the inductance of the primary coil suddenly increases, what limits the current through the primary coil. When the primary current which is too large has been shut off, the secondary coil may return into the superconducting state. The secondary coil may comprise one or a plurality of short-circuited windings.

As a disadvantage of this design, the inductance of the primary coil abruptly jumps by a large value upon a quench of the secondary coil. When protecting a power network, this may lead to a much larger drop in the primary current than needed for protection purposes, and more electricity consumers than necessary may experience a blackout.

EP 2 672 537 B1 describes a closed loop superconductive device made of a coated conductor, wherein a ratio of length L to width W is 0.5 ≤ L/W ≤ 10, and wherein an engineering resistivity ρ_{eng} > 2,5 Ohm, with R_{InShunt}=ρ_{eng}*L/W, with R_{InShunt} being the internal shunt resistance of the coated conductor. With these characteristics, the superconducting device has a reduced risk of burnout upon a quench. As a practical application, an inductive type fault current limiter is proposed, wherein the secondary coil consists of a plurality of sub-coils designed as above described superconducting devices, arranged next to each other within the primary coil.

### Object of the invention

It is the object of the invention to present an apparatus for current conditioning, which allows a smoother increase of the inductance of the primary coil when the primary current increases.

### Short description of the invention

This object is achieved, in accordance with the invention, by an apparatus as described in the beginning, characterized in
that at least a part of the secondary coils are arranged axially shifted to each other with respect to a direction of a primary magnetic flux of the primary coil, and that at least for said part of the secondary coils that are laterally shifted to each other, electrically insulating material is provided between the secondary coils.

According to the invention, the secondary coils are distributed both axially (along the direction of the primary flux) and laterally (transverse to the direction of the primary flux). Each secondary coil interacts only with a small part of the primary magnetic flux. When the primary current increases, one of the secondary coils is the first to quench. This in general increases the (non-compensated) primary magnetic flux in the primary coil, since the quenched secondary coil no more contributes to squeezing out the primary magnetic flux. As a result, the "effective inductance" (i.e. the inductance seen by a primary current transported in the primary coil) of the primary coil increases, what in turn reduces the primary current and thus stabilizes the superconductivity in the remaining superconducting secondary coils. However, the increase of the "effective inductance" is only relatively small, since the primary flux is spread to be compensated for is spread over a plurality of secondary coils, which may quench subsequently when the primary current further increases. By this means, a smooth increase of the effective inductance as a function of the primary current strength may be achieved.

Since the secondary coils are distributed both axially and laterally in accordance with the invention, the primary magnetic flux may be finely and purposefully covered for compensation purposes, and modelling the progress of the effective inductance of the primary when the primary current increases is particularly simple and may be done in various ways.

Note that typically, there are at least 10, often at least 15, and preferably at least 30 secondary coils contributing to a sequence of quench events as a function of the course of the primary current in an inventive apparatus, in order to obtain smooth transitions of the effective impedance. The sequence of quench events or events of resuming superconductivity is a result of the design of the inventive apparatus, and does not require any active (electronic) control. The quench events and events of resuming superconductivity of the respective secondary coils (or "flux switches") occur practically instantaneous, typically with a switching speed of <0.1 ms, after an external change of the primary current has happened. Accordingly, the overall inventive apparatus may provide correspondingly fast discrete steps of the effective impedance. Therefore, the inventive apparatus can be considered a "superconducting fast power multi-switch", which may provide a highly reliable, fast reacting fault current protection function, or may provide noise filtering for distortion frequencies up to the kHz range (such as up to 1 kHz or even up to 10 kHz).

The insulating material not only electrically insulates the secondary coils from each other so they may carry different currents, but also prevents voltage breakthroughs between the secondary coils, in particular upon quenching of one of the coils. Voltage breakthroughs will easily lead to a collapsing (quenching) of all secondary coils at a time, so an effective inductance increase of the primary coil would be very abrupt. By placing the insulating material, the interaction of the secondary coils may be limited to magnetic flux, which allows a much better control over the quenching sequence in the apparatus. The electrically insulating material is arranged between at least all laterally neighboring secondary coils, and preferably between all (laterally and axially) neighboring secondary coils. If desired, plates of insulating material may in particular be applied between layers of secondary coils.

Insulating materials used here are in general solid, preferably have a dielectric strength of at least 20kV/mm, most preferably at least 50kV/mm, and typically have a thickness of at least 10 mm, and the chosen insulating material arrangement preferably can stand a voltage difference between secondary coils of at least 200 kV, preferably at least 500 kV.

The primary flux is best visible in a quenched state of the secondary coils. Its direction is determined by its "core" (where the magnetic flux density has local maxima). Preferably, secondary coils interact with at least 50%, preferably at least 80%, most preferably at least 90%, of the primary flux. The secondary coils are in general "short-circuited", such that a circuit current may flow in them. Typically, a tape-type superconductor, in particular high temperature superconductor, is used for the secondary coils. Typically, the primary coil is normally conducting, e.g. made of a metal such as copper. However, the primary coil may also be superconducting.

### Preferred embodiments of the invention

### Embodiments relating to layers of secondary coils

A preferred embodiment of the inventive apparatus provides
that the secondary coils are arranged in a plurality of layers which are subsequent along the direction of the primary magnetic flux of the primary coil, with each layer comprising a plurality of the secondary coils,
and that in at least one of the layers, at least some of the secondary coils each overlap with at least two further secondary coils arranged in another layer or other layers than the layer of the respective secondary coil, wherein a part of each of the at least two further secondary coils does not overlap with the respective secondary coil.

The arrangement of secondary coils according to this embodiment facilitates a controlled spreading of a quenched zone from one secondary coil to the further secondary coils. The (partial) overlap facilitates a quenching of the further secondary coils after the secondary coil has quenched, and by means of the parts not overlapped by the secondary coil the quench may spread laterally more easily. By this means, a smoother increase of inductance seen by a primary current transported in the primary coil ("effective inductance") as a function of the primary current strength may be achieved.

The layers are arranged in a sequence, substantially along the (local) primary magnetic flux (also simply called primary flux) direction of the primary coil, preferably with the layers being perpendicular to the primary flux direction. In accordance with the embodiment, there are at least two secondary coils which only partially overlap with the respective secondary coil, and thus have a part not overlapping with the respective secondary coil; these partially overlapping secondary coils are called "further secondary coils". Note that other secondary coils may fully overlap with the respective secondary coil, so no part exists which does not have an overlap with the respective secondary coil; such other secondary coils are not considered "further secondary coils", though. A respective secondary coil typically overlaps in a particular layer with exactly two or none further secondary coils. Overlap is seen along the direction of the sequence.

A layer preferably comprises at least five secondary coils. Within a layer, the secondary coils are arranged next to each other, separated by insulating material. An apparatus according to this embodiment comprises at least two, preferably at least three, layers, and often at least six layers.

A preferred further development of this embodiment provides that said part of at least one of the further secondary coils overlaps with at least one next secondary coil in another layer than the layer of the respective further secondary coil,
and that a part of the next secondary coil neither overlaps with the further secondary coil, nor with the respective secondary coil. This further facilitates spreading of a quenched zone, namely to next secondary coils which do not overlap with the secondary coil where the quench started. The next secondary coil or coils, in turn, may overlap with a secondary coil or coils even farther away, and so forth. Preferably all secondary coils in all layers participate in a chain (or network) of mutual overlapping.

Optionally, the next secondary coil is arranged in the same layer as the respective secondary coil. In this way, a quench may be spread laterally in the layer of the respective secondary coil over the further secondary coils in a simple way, using magnetic flux.

In another further development, in each layer, each secondary coil overlaps with at least two further secondary coils arranged in another layer or other layers than the layer of the respective secondary coil, wherein a part of each of the at least two further secondary coils does not overlap with the respective secondary coil. A quench starting in any one of the secondary coils may be carried spread to other further secondary coils, and finally to all secondary coils of the apparatus.

Preferred is a further development, wherein at least two further secondary coils of the respective secondary coil are arranged in an identical layer. This keeps the secondary coil arrangement simple, and allows a branching of the quench in the layer of the further secondary coils.

Also preferred is a further development, wherein at least two further secondary coils of the respective secondary coil do not overlap with each other. This accelerates a lateral spreading of the quench.

In an advantageous further development, for at least some of the secondary coils, at least 5%, preferably at least 10%, of the inner cross-sectional area of a respective secondary coil does not overlap with any other secondary coils. In the non-overlapped cross-sectional area, no other secondary coils may take over the squeezing out of the primary magnetic flux out of the primary coil, and accordingly this non-overlapped cross-sectional area will safely lead to an increase of the effective inductance of the primary coil after quench of the respective secondary coil. This helps limiting the primary current and restabilizing of the secondary side of the apparatus after quench of one of its secondary coils.

Particularly preferred is a further development wherein in a number of N layers, with N a natural number ≥2,
- at least some of the secondary coils of a respective layer are periodically arranged in a circumferential direction, with an angle period AP,
- and the angular positions of at least some of the secondary coils are shifted
between the layers in steps of an angle AP/N. This arrangement is simple to realize and allows a well-controlled mutual overlapping, with lateral spread-out. Note that substructures of said N layers may repeat in the apparatus.

In another preferred further development, the apparatus comprises substructures periodic in a direction of the sequence of layers, with each substructure comprising a plurality of layers. This simplifies the design and allows a systematic multiple coverage of primary magnetic flux, for example for handling particularly high primary currents.

### Further embodiments

Preferred is also an embodiment wherein the entirety of secondary coils is designed such that it interacts with at least 50%, preferably at least 80%, most preferably at least 90% of the primary magnetic flux in a quenched state of the secondary coils. This allows a particularly strong increase of inductance of the primary coil upon (complete) quench of the secondary side of the apparatus, and thus a strong limitation of the primary current. The fraction of coverage is easy to obtain with multiple layers of secondary coils (see above) and/or with shapes of the secondary coils adapted to the shape of the primary coil.

In another preferred embodiment, at least some of the secondary coils, and preferably all secondary coils, are of closed loop type. A one turn closed loop design is particularly simple to manufacture and to nest, if desired.

In a particularly preferred embodiment, at least some of the secondary coils have a non-circular cross-section, in particular a basically sector-shaped cross-section. This simplifies a high coverage of the primary magnetic flux, in particular if the primary coil is of circular shape.

In an advantageous embodiment, at least some secondary coils exhibit different critical currents. This simplifies establishing a desired sequence of quenches of secondary coils as a function of the primary current in order to establish a smooth increase of the effective inductance of the primary coil, and in particular simplifies avoiding concurrent quenches of secondary coils.

Preferred is also an embodiment wherein at least some of the secondary coils comprise a plurality of nested closed loop type subcoils each. This may be used to adjust (set) the critical currents of the secondary coils. Further, with nested subcoils, higher critical currents may be achieved, and thus higher magnetic flux can be compensated.

In an advantageous embodiment, all secondary coils are electrically insulated from each other, using insulating material arranged between the secondary coils. This avoids voltage breakthroughs between the secondary coils, and thus uncontrolled spreading of a quench, in particular also in axial direction.

Further preferred is an embodiment wherein at least in some of the secondary coils, ferromagnetic material is arranged in the cross-section of each respective secondary coil,
in particular wherein the ferromagnetic material fills 20% or less of the cross-section of a respective secondary coil. By means of the ferromagnetic material, the (primary) magnetic flux may be guided, and coupling between the primary coil and the secondary coils may be intensified. By filling only part of the cross-sections of the secondary coils, redirecting of magnetic flux upon quench of a part of the secondary coils is simplified, what improves a smooth increase of the effective inductance of the primary coil. Note that alternatively, no ferromagnetic material is arranged in the cross-section of the secondary coils at all.

In an advantageous embodiment, the ferromagnetic material arranged in the cross-section of a respective secondary coil does not axially extend beyond the respective secondary coil. This again simplifies redirection of magnetic flux upon a quench of a part of the secondary coils, what again what improves a smooth increase of the effective inductance of the primary coil. Further, thermal and/or electrical insulation between layers of secondary coils may be simplified.

A preferred embodiment provides that the secondary coils are arranged radially within the primary coil. Radially within the primary coil, the (primary) magnetic flux density is particularly high, so a high coverage of the primary magnetic flux is simplified. Typically, the secondary coils are arranged also axially within the primary coil. This embodiment allows a simple and compact design.

In an advantageous further development of the above embodiment, the entirety of secondary coils overlaps with at least 50%, preferably at least 80%, most preferably at least 90%, of the cross-section of the primary coil. This again allows a particularly strong relative increase of inductance of the primary coil upon (complete) quench of the secondary side of the apparatus, and thus a strong limitation of the primary current.

In another preferred embodiment, at least some of the secondary coils are arranged shifted away from the primary coil along a direction of the primary magnetic flux of the primary coil, in particular wherein the secondary coils are arranged on a torus. This design allows an increased space for the secondary coils, at least in parts unhindered by the primary coil. In this way, particularly high primary currents can be handled. Note that for directing the primary magnetic flux, often ferromagnetic material and/or a closed torus of secondary coils is used in this embodiment.

An advantageous embodiment provides that a plurality of ferromagnetic yokes is provided, with each yoke running through the primary coil and one or a plurality of secondary coils. By using multiple ferromagnetic yokes, these can be distributed among secondary coils (of different layers) which are laterally shifted with respect to each other. This can for example be used for controlling the spread of (primary) magnetic flux upon quenching of a part of the secondary coils.

In another preferred embodiment, the insulating material is a compound material comprising at least two dielectric material layers with a metallic material layer arranged between the dielectric material layers, in particular wherein the thickness of the metallic material layer is less than 1/10 of the thickness of each of the dielectric material layers. The metallic material layer homogenizes the electric field in the compound material, making it more resistant against voltage breakthroughs as compared to the combined thickness of the other dielectric (electrically insulating) material layers.

A preferred embodiment of the inventive apparatus provides
that the secondary coils are arranged in a plurality of layers which are subsequent along the direction of the primary magnetic flux of the primary coil, with each layer comprising a plurality of the secondary coils,
and that the apparatus further comprises a cryostat arrangement with a plurality of separate cryocontainers, in particular wherein each cryocontainer is filled with a cryogen such as liquid helium, and wherein each cryocontainer contains at least one layer of secondary coils, in particular wherein the separate cryocontainers are arranged in separate vacuum containers. By using separate cryocontainers (or cryocompartments), uncontrolled spreading of a quench due to warming in a quenched secondary coil in a first cryocontainer to a secondary coil in another cryocontainer is avoided or at least impeded. In the most simple case, the cryostat arrangement comprises a number of separate cryostats, one for each cryocontainer. However, it is also possible to use a common vacuum container for a plurality of cryocontainers, or a common frame and/or a common vacuum pump for a number of vacuum containers. Preferably, there is a separate cryocontainer for each layer. Separate vacuum containers for each cryocontainer improve the thermal insulation further.

The present invention also relates to a use of an inventive apparatus described above as a fault current limiter, wherein a primary current to be limited is transported in the primary coil.

### Inventive methods for current conditioning

The present invention further relates to a method for current conditioning, wherein a primary current to be conditioned is transported in a primary coil of electrically conducting material,
and wherein a primary magnetic flux of the primary coil interacts with a plurality of secondary coils of superconductor material and induces secondary currents in the secondary coils,
wherein at least for a part of the secondary coils, the secondary coils interact with different parts of the primary magnetic flux each,
in particular wherein the primary coil and the secondary coils belong to an inventive apparatus described above,
characterized in
that at least for a part of the secondary coils, the secondary coils interact with identical parts of the primary magnetic flux at different axial positions along the direction of the primary magnetic flux each,
that at least for said part of the secondary coils interacting with different parts of the primary magnetic flux, a voltage breakthrough between the secondary coils is prevented by arranging an insulation material between these secondary coils, and that the primary current is conditioned by subsequent quenching and/or resuming superconductivity of secondary coils or groups of secondary coils when the primary current changes. According to the inventive method, the primary magnetic flux is spread over a plurality of secondary coils interacting with different parts of the primary magnetic flux, and further the primary magnetic flux couples some of the secondary coils which interact with identical parts of the primary magnetic flux. In this way, it is possible to establish a well-controlled sequence of quenching (or of resuming superconductivity) of secondary coils as a function of the primary current. Further, uncontrolled quenching due to voltage breakthroughs between secondary coils at least of the secondary coils interacting with different parts of the primary magnetic flux (and preferably between all secondary coils) is avoided by the insulation material arranged. Since the established sequence of quenching (or of resuming superconductivity) determines the effective inductance of the primary coil, a particularly smooth increase of the effective inductance of the primary coil as a function of the primary current can be achieved by means of the inventive method.

In a preferred variant of the inventive method, the secondary coils are chosen and arranged such that for a plurality of portions of the primary magnetic flux, each portion
- fully interacts with at least one secondary coil,
- and interacts, in particular partially interacts, with at least two further secondary coils,
wherein each of the further secondary coils interacts, in particular partially interacts, also with at least one further portion of the primary magnetic flux which does not interact with the respective secondary coil. By this means, a controlled spreading of a quench over the secondary coils may be achieved. When for example the secondary coil fully interacting with a particular portion of the primary magnetic flux quenches, the at least two further secondary coils interacting with the same portion will have an increased current load for compensating said portion. If the current load exceeds the critical current of a further secondary coil, this further secondary coil will also quench. Note that the secondary coil and a further secondary coil interact with the portion of the primary magnetic flux at different positions along the primary flux direction.

Preferred is also a further development of this variant all secondary coils act as further secondary coils with respect to at least two different portions of the primary magnetic flux. By this means, a network of coupled secondary coils may be established in an easy way.

In an advantageous variant, the secondary coils are chosen and arranged such that a desired characteristic of an increase of an effective inductance of the primary coil is achieved when the primary current is increased,
in particular wherein the following applies:
IP2-IP1 ≥ 0.3*IP1, preferably IP2-IP1 ≥ 0.5*IP1,
and/or Z2-Z1 ≥ 0.8*Z1, preferably Z2-Z1 ≥ 1.5*Z1,
with IP1: primary current when a first secondary coil quenches, IP2: primary current when a last secondary coil quenches, Z1: effective inductance of the primary coil before the first secondary coil quenches, Z2: effective inductance of the primary coil after the last secondary coil quenches. The inventive method allows a good control over the effective inductance as a function of the course of the primary current. With IP2-IP1 ≥ 0.3*IP1, the protection function can be distributed over a considerable dynamic range of the primary current. With Z2-Z1 ≥ 0.8*Z1, a significant protection or additional inductance, respectively, can be achieved. The values can be well achieved by means of the invention. The effective inductance of the primary coil is the inductance seen by the primary current, and depends on the state (superconducting/non-superconducting) of the secondary coils. The inductance increase with increasing primary current is preferably basically linear.

In another preferred variant, the primary current is an AC current or a DC current with a current noise. By means of the invention, the current noise can be reduced. For this purpose, an average AC current or DC current should be chosen with a magnitude such that a part of the secondary coils (but not none, and not all) are in a quenched state. For example, at least 10% but not more than 90% of the secondary may be at a quenched state at the average AC current or DC current. The noise causes some further secondary coils to quench or to resume superconductivity, but not all of them, what adapts the effective inductance to the instant current, what in turn smoothes the current magnitude.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing

The invention is shown in the drawing.
- Fig. 1: shows a schematic perspective view of a first embodiment of an inventive apparatus, with two layers of aligned secondary coils;
- Fig. 2: shows a schematic perspective view of a second embodiment of an inventive apparatus, with three layers of aligned secondary coils, with each secondary coil comprising two nested subcoils each;
- Fig. 3a: shows a schematic perspective view of a third embodiment of an inventive apparatus, with two layers of secondary coils, wherein the secondary coils of different layers are laterally shifted with respect to each other;
- Fig. 3b: shows a schematic plan view of the apparatus of Fig. 3a;
- Fig. 4: shows a schematic plan view of a fourth embodiment of an inventive apparatus, with two layers of secondary coils, wherein the secondary coils of different layers are laterally shifted with respect to each other, and with a central secondary coil in each layer;
- Fig. 5a: shows a schematic plan view of a fifth embodiment of an inventive apparatus, with five sector-shaped secondary coils in two layers each, wherein the layers are rotated by half a sector width;
- Fig. 5b: shows a schematic plan view of the apparatus of Fig. 5a, showing only one of the layers, together with insulating material;
- Fig. 5c: shows an alternative arrangement of insulating material for the apparatus of Fig. 5b;
- Fig. 5d: shows an alternative design of a sector shaped secondary coil for the apparatus of Fig. 5b, comprising two nested subcoils;
- Fig. 5e: shows an alternative design of sector-shaped coils for a layer of the apparatus of Fig. 5a, with a different number of nested subcoils in the sectors;
- Fig. 6: shows a schematic side view of a sixth embodiment of an inventive apparatus, comprising three layers of sector-shaped secondary coils, rotated from layer to layer;
- Fig. 7: shows a schematic side view of a seventh embodiment of an inventive apparatus, comprising two layers of sector-shaped secondary coils, rotated from layer to layer, with ferromagnetic yokes;
- Fig. 8a: shows a schematic perspective view of an eighth embodiment of an inventive apparatus, with torus shaped arranged secondary coils;
- Fig. 8b: shows a schematic, partially cut perspective view of a variant of the apparatus of Fig. 8a, with the secondary coils arranged as part of a torus;
- Fig. 9: shows a schematic view of a ninth embodiment of an inventive apparatus, with a split primary coil and layers of secondary coils distributed over two cryocontainers, linked with ferromagnetic yokes;
- Fig. 10: shows a tenth embodiment of an inventive apparatus, having secondary coils in three substructures arranged in a periodic sequence, with each substructure having two layers of secondary coils;
- Fig. 11: shows a schematic cross-sectional view of an eleventh embodiment of an inventive apparatus, illustrating the magnetic flux;
- Fig. 12: shows a schematic diagram illustrating the effective inductance Z as a function of the course of the primary current, in accordance with the invention;
- Fig. 13: shows a schematic cross-section of a plate of insulating material for the invention.

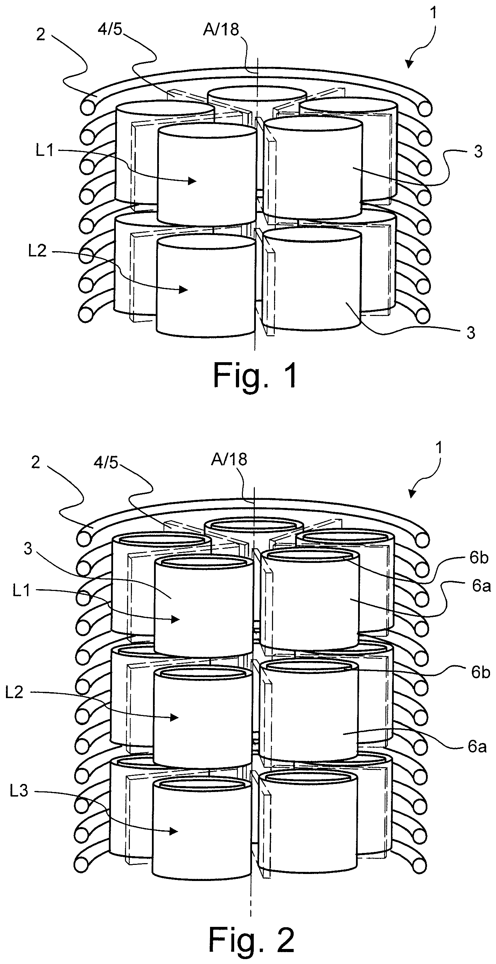

**Fig. 1** shows a first embodiment of an inventive apparatus 1 for current conditioning.

The apparatus 1 of the illustrated embodiment comprises a normally conducting (i.e. non-superconducting) primary coil 2 here of solenoid type, and a plurality of superconducting secondary coils 3. The secondary coils 3 are here of single turn, circular, closed loop type each, and may for example be manufactured by coating a hollow carrier cylinder with a superconducting layer, such as YBCO. Alternatively, the secondary coils 3 may be made of a piece of tape-type superconductor, bent to form a loop, and superconductively short circuited with a further piece of tape-type superconductor which is soldered in a face-to-face way where the "face" side is with superconductive layer, in particular HTS layer.

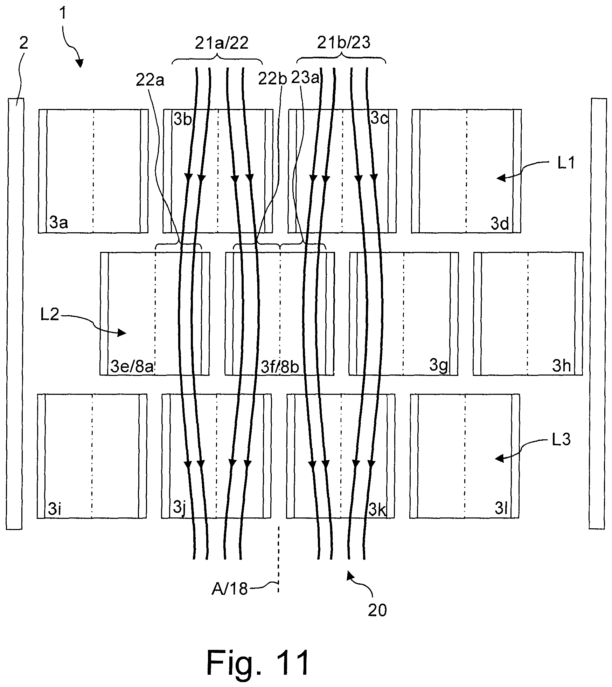

In the arrangement shown, the secondary coils 3 are arranged in two layers L1, L2, each comprising five secondary coils 3, with the secondary coils 3 of the different layers L1, L2 aligned with each other in axial direction, compare axis A. The layers L1, L2 are subsequent along the axis A of the primary coil solenoid, and thus along a direction 18 of a primary magnetic flux of the primary coil 2 within said primary coil 2 (not shown in detail, but compare Fig. 11).

The secondary coils 3 in layer L2 are axially shifted with respect to the secondary coils 3 in layer L1. Further, the five secondary coils 3 in each of the layers L1, L2 are laterally shifted with respect to each other.

Between neighboring secondary coils 3 in the same layer L1, L2, plates 4 of an electrically insulating material 5 are arranged (marked with dashed lines). The secondary coils 3 are arranged here axially and radially within the primary coil 2, what results in a compact design.

Preferably, plates of insulating material are also provided between the layers L1, L2 (not shown in detail).

**Fig. 2** shows a second embodiment of an inventive apparatus 1 for current conditioning, similar to the apparatus shown in Fig. 1, so only the main differences are discussed.

In this embodiment, secondary coils 3 are arranged in three layers L1, L2, L3 arranged subsequent along the axis A of the primary coil solenoid. In each layer L1, L2, L3, five secondary coils 3 are distributed regularly in circumferential direction. Again, the secondary soils 3 of the different layers L1, L2, L3 are aligned with each other.

Each secondary coil 3 here comprises two nested subcoils 6a, 6b, with each subcoil 6a, 6b providing its own superconducting closed loop.

The apparatus 1 of Fig. 2 allows compensation for a stronger primary magnetic flux as compared to the first embodiment of Fig. 1.

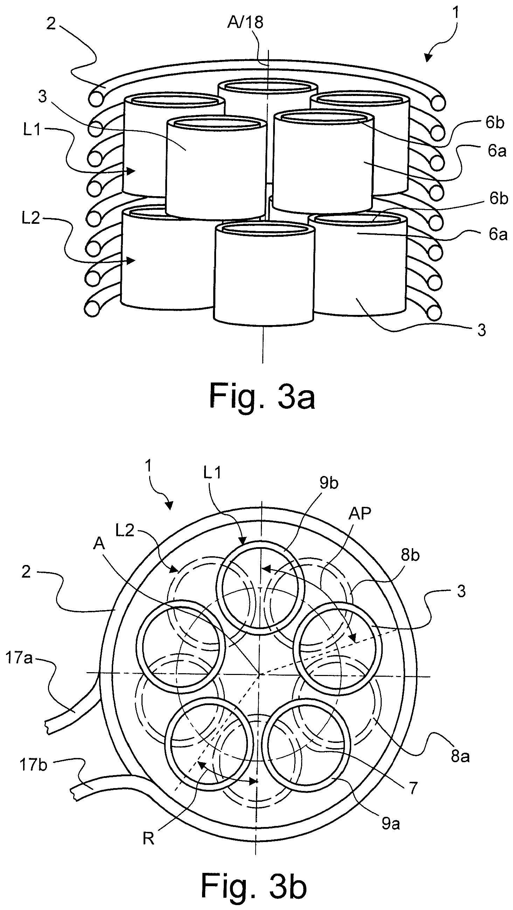

**Fig. 3a** in perspective view and **Fig. 3b** in plan view show a third embodiment of an inventive apparatus 1 for current conditioning.

Radially and axially within the primary coil 2 are provided circular, closed-loop type secondary coils 3, each with two nested subcoils 6a, 6b. The secondary coils 3 are arranged here in N=2 layers L1, L2 (in Fig. 3b, the secondary coils 3 of the first layer L1 are shown with continuous lines, and the secondary coils 3 of the second layer L2 are shown with dashed lines). For simplification, insulating material is not shown in Fig. 3a and Fig. 3b (but compare e.g. Fig. 1 and Fig. 2).

Each layer L1, L2 contains M=5 secondary coils 3 regularly distributed on a circle 7, such that secondary coils 3 repeat periodically in a circumferential direction with an angle period AP of 360°/ M = 72°.

The secondary coils 3 of the first layer L1 are shifted laterally with respect to the secondary coils 3 of the second layer L2 by means of a rotation R of half an angle period AP/2 = 36°. Each secondary coil 3 in one of the layers L1, L2 (in Fig. 3b with secondary coil 3 shown in layer L1) overlaps with two further secondary coils 8a, 8b in the other layer L1, L2 (in Fig. 3a in layer L2), with respect to the axial direction (parallel to axis A of the primary coil solenoid) which corresponds to the direction 18 of the primary magnetic flux. In the embodiment shown, each further secondary coil 8a, 8b overlaps with about 25% of the inner cross-section of the respective secondary coil 3. About 50% of the inner cross-section of the respective secondary coil 3 does not overlap with any other secondary coil here.

In turn, each of the further secondary coils 8a, 8b overlaps with a next secondary coil 9a, 9b. Said next secondary coil 9a, 9b is here arranged in the layer L1, L2 of said respective secondary coil 3 again (in Fig. 3b in layer L1). The next secondary coil 9a, 9b has a part that does not overlap with the respective further secondary coil 8a, 8b and also does not overlap with the respective secondary coil 3.

In the example shown, about 60% of the inner cross-section of the primary coil 2 (and thus basically of the primary magnetic flux) is overlapped by at least one secondary coil 3.

In Fig. 3b, there are also shown electrical connections 17a, 17b for feeding a primary current into the primary coil 2, in particular for limiting or smoothing said primary current by means of the apparatus 1.

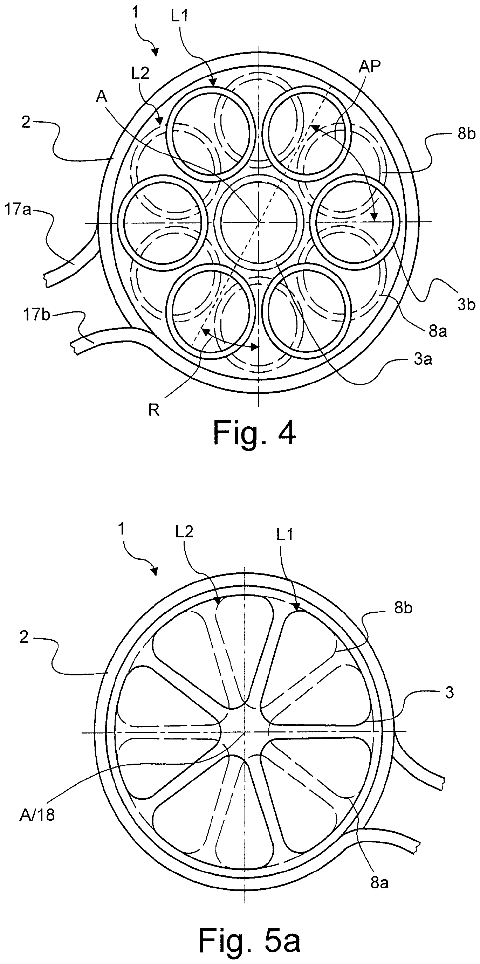

**Fig. 4** shows in schematic plan view a fourth embodiment of an inventive apparatus 1 for current conditioning. Only the main differences with respect to the embodiment of Fig. 3b are further explained.

In this embodiment, each of the N=2 layers L1 (shown with continuous lines) and L2 (shown with dashed lines) comprises seven secondary coils 3a, 3b, with one central secondary coil 3a and M=6 secondary coils 3b regularly distributed on a circle, such that the latter secondary coils 3b repeat periodically in a circumferential direction with an angle period AP of 360°/ M = 60°.

The non-central secondary coils 3b of the first layer L1 are shifted laterally with respect to the non-central secondary coils of the second layer L2 by means of a rotation R of half an angle period AP/2 = 30°. Each non-central secondary coil 3b in one of the layers L1, L2 overlaps with two further secondary coils 8a, 8b in the other layer L1, L2, with respect to the axial direction (parallel to axis A of the primary coil solenoid). The central secondary coils 3a of both layers L1, L2 overlap fully with each other and with no other secondary coils in this embodiment.

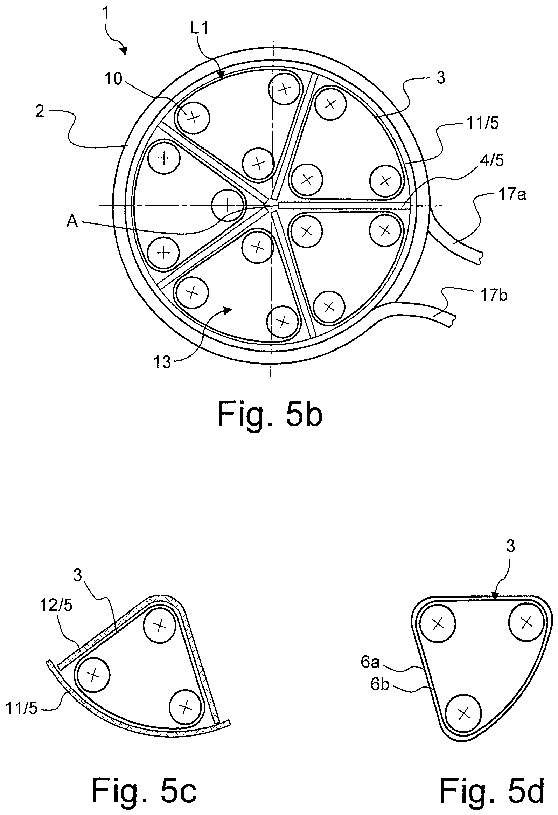

**Fig. 5a** shows in a schematic plan view a fifth embodiment of an inventive apparatus 1, similar to the embodiment shown in Fig. 3b, so only the major differences are explained in detail. For simplification, insulating material is not shown (but compare Fig. 5b).

In this embodiment, the secondary coils 3 of the N=2 layers L1, L2 have a non-circular cross-section (seen in a plane perpendicular to the axis A of the primary coil solenoid or the direction 18 of the primary magnetic flux, respectively), namely a basically sector-shaped cross-section. In each layer L1, L2, there are M=5 secondary coils 3. Each secondary coil 3 of one of the layers L1, L2 overlaps with two secondary coils 8a, 8b of the other layer L1, L2.

By means of the sector-shaped secondary coils 3, a high coverage of the primary magnetic flux (i.e. the magnetic flux generated by the primary coil 2) can be achieved, here about 80% of the primary magnetic flux, corresponding to about 80% of the inner cross-section of the primary coil 2. Further, about 80% of the inner cross-section of each secondary coil 3 is overlapped by further secondary coils 8a, 8b, whereas about 20% of said inner cross-section are not overlapped by further secondary coils 8a, 8b or any other secondary coils.

**Fig. 5b** illustrates the apparatus 1 of Fig. 5a in more detail on the level of the first layer L1. The secondary coils 3 here each have three supports 10 of cylindrical shape, located at the "corners" of the respective secondary coil 3 each. The conductor tape of the secondary coil 3 is bent around the supports 10. The supports 10 only extend in their layer, here layer L1, and not into neighboring layers. Preferably, the supports 10 are made of ferromagnetic material, so that higher primary magnetic fluxes can be compensated for by means of a secondary coil 3.

In circumferential direction between neighboring secondary coils 3, there are provided plates 4 of electrically insulating material 5. The plates 4 extend from a coil center (close to axis A) to a jacket tube 11, also made of electrically insulating material 5. The insulating material 5 may comprise, for example, Si₃N₄ or other ceramic material, or a plastic material.

By means of the insulating material 5, sector-shaped compartments 13 are formed in the respective layer, here layer L1, for the secondary coils 3.

**Fig. 5c** shows an alternative arrangement of the insulating material 5 for the secondary coils 3. In the example shown, a V-shaped bent plate 12 of insulating material 5 roofs each secondary coil 3 on its flat sides neighboring other secondary coils in circumferential direction.

As illustrated in **Fig. 5d****,** the basically sector-shaped secondary coil 3 may comprise a multitude of nested subcoils 6a, 6b, for example two subcoils as shown.

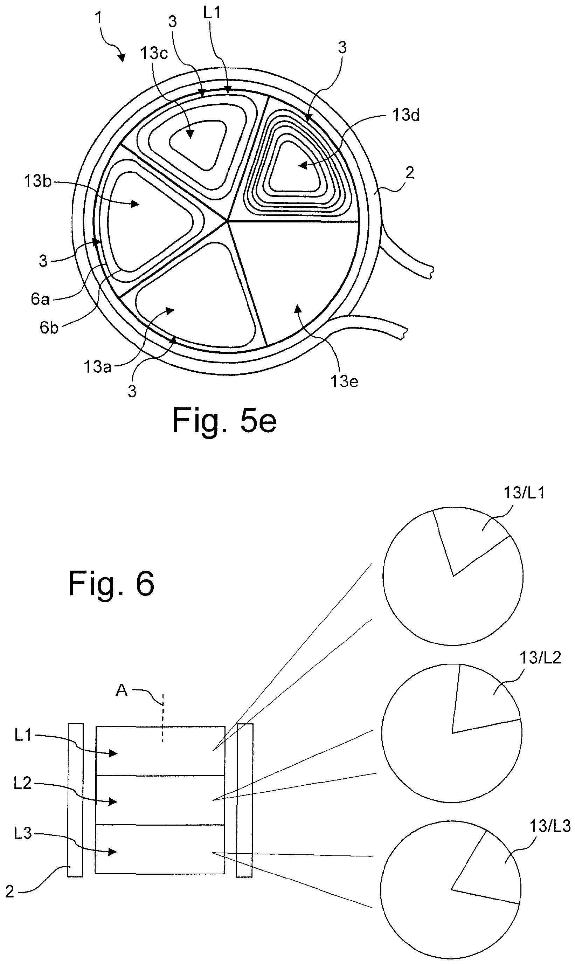

In a variant of the design of Fig. 5b, a different number of subcoils may be applied for at least some of the secondary coils 3 of a layer, compare **Fig. 5e****.** In the example shown, there are five sector-shape compartments 13a, 13b, 13c, 13d, 13e in the layer L1 of apparatus 1, four of which 13a-13d are filled with a secondary coil 3 each, and one sector-shaped compartment 13e being without a secondary coil.

The secondary coil 3 in compartment 13a is of simple unnested structure. In compartment 13b, the secondary coil 3 comprises two nested subcoils 6a, 6b.

In compartment 13c, the secondary coil 3 comprises three nested subcoils. In compartment 13d, the secondary coil 3 comprises six nested subcoils.

By means of the structure of the secondary coils 3, and in particular by means of the number of subcoils, a critical current of a secondary coil 3 can be chosen. Note that a larger amount of subcoils typically results in a higher total critical current of the secondary coil 3, since the current can be distributed over more conductor tape cross-sectional area; remember that superconductivity is limited by a critical current density.

An empty compartment 13e may be useful in adjusting an initial (effective) inductance of the primary coil 2 when all secondary coils 3 are still superconducting; the empty compartment 13e (assuming that in the other layers at least part of the empty compartment is not overlapped by secondary coils there) allows some primary magnetic flux to remain uncompensated, so that the primary coil 2 exhibits some non-zero minimum inductance, what may be desired in order to establish a minimum AC resistance for the primary current by means of the apparatus 1.

In **Fig. 6****,** a sixth embodiment of an inventive apparatus 1 is shown in a side view on the left hand side of Fig. 6. Radially and axially within the primary coil 2 there are three (N=3) layers L1, L2, L3 of secondary coils (not shown in detail, but compare e.g. Fig. 5b) arranged in compartments 13; for each layer L1, L2, L3, a compartment 13 is shown in plan view (parallel to the axial direction) on the right hand side of Fig. 6.

In each layer L1, L2, L3, here five (M=5) compartments 13 are provided, only one of which is shown for simplification in each case. The compartments 13 are arranged periodically in circumferential direction in each layer L1-L3, with an angle period 360°/M=72°, corresponding to the angular width of a compartment 13. From layer to layer, the compartments 13 are shifted (rotated) by an angle of 72°/3=24°, so that a partial overlap with compartments 13 (and thus of the secondary coils contained, not shown) in respective other layers L1-L3 occurs.

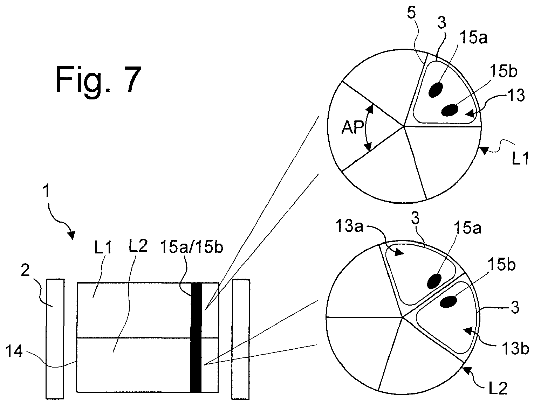

In **Fig. 7****,** a seventh embodiment of an inventive apparatus 1 is shown, similar to the one shown in Fig. 6, so only the major differences are explained.

In this embodiment, the secondary side 14 comprises only two (N=2) layers L1, L2 of secondary coils 3, again with five (M=5) compartments 13, 13a, 13b within each layer L1, L2, arranged periodically with the angle period AP of 360°/M=72°. The respective compartments 13, 13a, 13b of different layers L1, L2 are rotated by 72°/2=36°.

In the embodiment shown, ferromagnetic yokes 15a, 15b are used which extend through both layers L1, L2. In Fig. 7, only one pair of yokes 15a, 15b is shown for simplification, however the apparatus 1 comprises five such pairs, distributed in circumferential direction according to the angle period AP (here 72°).

The yokes 15a, 15b are arranged such that in layer L1, both yokes 15a, 15b of the pair are within the same secondary coil 3 of compartment 13, and that in layer L2 below, the yokes 15a, 15b are within different secondary coils 3 of compartments 13a, 13b. Note that within the secondary coil 3 of compartment 13a, another yoke of a different pair will be located, too (not shown), and the same is true for secondary coil 3 of compartment 13b. The yokes 15a, 15b each have an angular width small enough such that they fit in the common overlapping area of the secondary coils 3 which they run through.

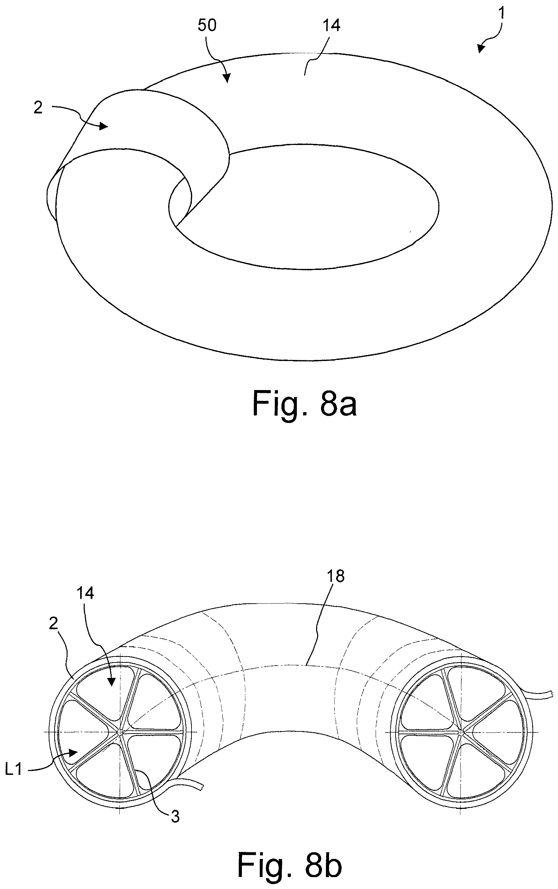

**Fig. 8a** shows an eighth embodiment of an inventive apparatus 1. In this embodiment, the secondary side 14 of the apparatus 1 is of a closed ring shape, and here has the form of a torus 50.

The secondary side 14 leads through the primary coil 2. The primary magnetic flux of the primary coil 2 is for the largest part guided and encased by the secondary side 14.

The secondary side 14 comprises a plurality of layers of secondary coils (not shown in detail), with the layers arranged subsequent along the torus 50. Since the primary magnetic flux runs also along the torus 50, said layers are also arranged subsequent along the primary magnetic flux (or its respective core).

**Fig. 8b** illustrates a variant of an inventive apparatus 1 in a partially cut perspective view, also based on a torus-like secondary side 14. In this variant, the primary coil 2 is wound with a wire like a solenoid on the outside of the secondary side 14, and the secondary side 14 describes a part of a torus, here about half a torus. The secondary side 14 comprises a plurality of layers (see e.g. layer L1 on the left hand side) of secondary coils 3, here of basically sector shape (compare also Fig. 5b); secondary coils 3 of subsequent layers are rotated with respect to each other such that only partial overlap occurs (see Fig. 5a for example). Said layers are arranged subsequent along the part of a torus or along the primary magnetic flux direction 18, respectively.

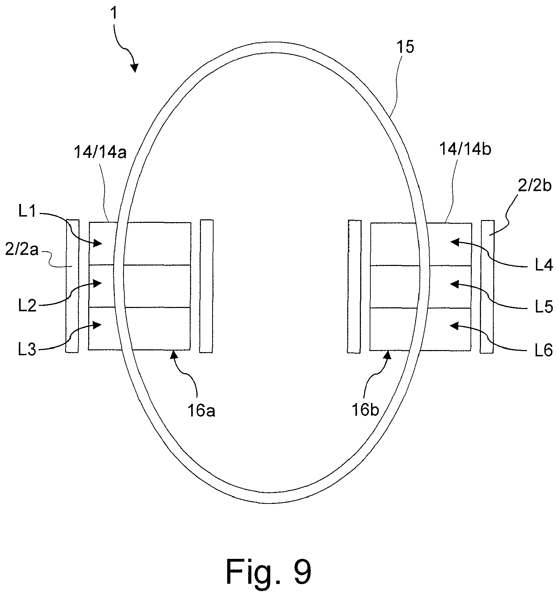

**Fig. 9** shows a ninth embodiment of an inventive apparatus 1 for current conditioning. In this embodiment, the primary coil 2 is split into a first part 2a and a second part 2b; typically these parts 2a, 2b are electrically connected in series, so they are flown through by the same primary current. Radially and axially within each part 2a, 2b are arranged a number of layers of secondary coils, here three layers L1, L2, L3 in the left part 2a and three layers L4, L5, L6 in the right part 2b. Accordingly, the secondary side 14 here has a first part 14a and a second part 14b, too.

Closed ring type ferromagnetic yokes 15 (only one of which is shown for simplification) run through both parts 2a, 2b of the primary coil 2 and both parts 14a, 14b of the secondary side 14; said yokes 15 basically guide the primary magnetic flux of the primary coil 2.

In this embodiment, layers L1, L2, L3 of secondary coils are arranged in a first cryocontainer 16a, and layers L4, L5, L6 are arranged in a second cryocontainer 16b, wherein the cryocontainers 16a, 16b are separate and thermally insulated from each other. The cryocontainers 16a, 16b together form a cryostat arrangement. In the embodiment shown, the cryocontainers 16a, 16b contain a cryogen such as LN2 or LHe for cooling the secondary coils; however cryogen-free cryocontainers may be used, too.

Note that alternatively, is also possible to have a separate and thermally insulated cryocontainer (or cryocompartment) for each layer L1-L6.

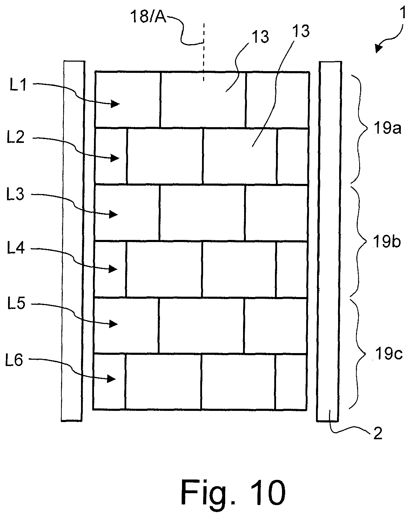

**Fig. 10** illustrates a tenth embodiment of an inventive apparatus 1 for current conditioning. In this embodiment, six layers L1-L6 of secondary coils are arranged radially and axially within the primary coil 2. Note that only the compartments 13 for the secondary coils are shown in the layers L1-L6 for simplicity.

The compartments 13 resp. the corresponding secondary coils of layers L1 and L2 are laterally (i.e. transverse to axis A or the primary magnetic flux direction 18) shifted. However, the compartments 13 resp. the corresponding secondary coils of layers L1, L3, L5 are aligned (not shifted), and the compartments 13 resp. the corresponding secondary coils of layers L2, L4, L6 are aligned (not shifted).

Accordingly, layers L1, L2 form a substructure 19a that repeats itself as substructure 19b and substructure 19c along the axis A. Designs with periodic substructures 19a-19c are used above all if high primary currents have to be handled.

**Fig. 11** illustrates the primary magnetic flux distribution in an eleventh embodiment of an inventive apparatus 1. The apparatus 1 comprises here three layers L1, L2, L3 of secondary coils 3a-3l; the secondary coils 3e-3h of layer L2 are laterally shifted with respect to the secondary coils 3a-3d, 3i-3l of layers L1, L3. The layers L1, L2, L3 are arranged subsequent along axis A of the primary coil 2, which basically corresponds to the primary magnetic flux direction 18. All secondary coils 3a-3l are of closed single loop type here, made of YBCO tape. The basically cylindrical primary coil 2, inside of which the secondary coils 3a-3l are arranged, is normally conducting and made of a metal such as copper. Note that for simplicity, insulating material is not shown in Fig. 11 (but compare Fig. 1 or Fig. 5b for example).

When a primary current runs through the primary coil 2, a primary magnetic flux 20 is generated, which runs basically along an axis A of the primary coil 2; note that Fig. 11 illustrates only part of the total primary magnetic flux 20. The primary flux 20 can be well observed as long as the secondary coils 3a-3l are in a normally conducting state (and accordingly hardly carry any induced currents opposing the primary flux 20). This situation is shown in Fig. 11. Note that when the secondary coils 3a-3l are superconducting (e.g. after sufficient cooling), the secondary coils 3a-3l "expel" magnetic flux from their interior, i.e. secondary currents induced in the secondary coils 3a-3l generate a secondary magnetic flux which is opposed to the primary flux 20 and compensates it; this effect lowers the effective inductance of the primary coil 2.

Secondary coils 3a-3l in the same layer L1-L3 generally interact with (i.e. have running through them) different parts of the primary magnetic flux 20. For example, part 21a interacting with secondary coil 3b is different from part 21b interacting with secondary coil 3c.

Further, the shifted arrangement of the secondary coils 3a-3l in layer L2 with respect to layers L1, L3 leads to some lateral coupling. For example, a portion 22 of primary magnetic flux 20, which fully interacts with secondary coil 3b in layer L1, also partially interacts with secondary coils 3e, 3f in layer L2, also called further secondary coils 8a, 8b. The latter means that a subportion 22a of portion 22 runs through further secondary coil 8a, and a subportion 22b of portion 22 runs through further secondary coil 8b. In other words, the subportion 22a ("identical part") interacts both with secondary coil 3b in layer L1 and with further secondary coil 8a in layer L2, and subportion 22b ("identical part") interacts both with secondary coil 3b in layer L1 and with further secondary coil 8b in layer L2. It should be noted that further secondary coil 8b also partially interacts with further portion 23 of the primary magnetic flux 20, i.e. subportion 23a of further portion 23 runs through further secondary coil 8b, too. Said further portion 23 interacts in layer L1 with secondary coil 3c, but not with secondary coil 3b. It should be noted that the situation is symmetric, so further portion 23 also represents a "portion", and portion 22 represents a "further portion" in the sense above.

As an example, during normal operation, e.g. limiting a primary current through primary coil 2, secondary coil 3b in layer L1 in the superconducting state partially "protects" secondary coils 3e, 3f from some primary magnetic flux 20. When secondary coil 3b quenches, the secondary coils 3e, 3f are exposed to "more" primary magnetic flux than before that has to be compensated for; this brings them closer to a quench themselves, but typically the quench does not occur in secondary coils 3e, 3f until the primary current has increased some more. The lateral shift among the secondary coils 3a-3l makes it possible to spread or distribute the increased current load onto different secondary coils 3a-3l in a next layer, such that immediate collapse in the next layer typically does not occur. However, the loss of secondary coil 3b in general increases the effective inductance of primary coil 2. With a sufficient number of secondary coils, this allows a very smooth change of the effective inductance as a function of the course of the primary current. Note that the critical currents of the secondary coils 3a-3l may be adjusted, in particular to be unequal among the secondary coils 3a-3l, in order to achieve a desired quenching characteristic.

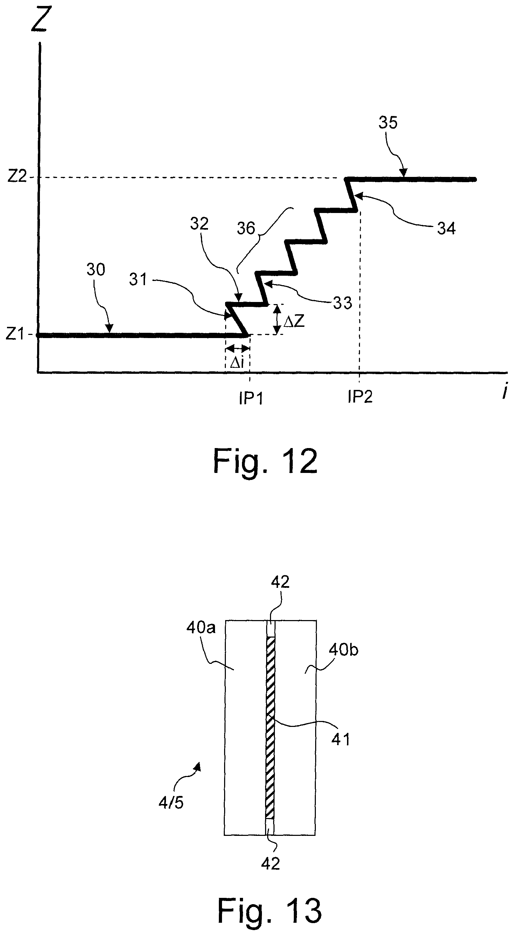

**Fig. 12** shows a schematic diagram illustrating the effective inductance Z (upward axis) of an inventive apparatus as a function of the course of a primary current i (right axis), in accordance with the invention.

In a typical power network setup, an AC (alternating current) voltage source is connected to a consumer network via an inventive apparatus which is used as a current limiter. In the consumer network, the number of parallel consumers may vary over time; if the number of parallel consumers increases, the current consumed by them increases. This leads to an increase of the primary current at the apparatus, which is connected in series. In turn, when the number of parallel consumers decreases, the primary current decreases.

Let us assume that as a consequence of the behavior of the consumers, the number of parallel consumers increases continuously over time.

In the beginning, the see early phase 30, the primary current simply increases, since the (ohmic) resistance of the consumer network, which is in series with the inventive apparatus, decreases. As long as the primary current I stays below IP1, all secondary coils in the apparatus stay superconducting, and so the effective inductance Z remains constant at Z1.

When the primary current I reaches IP1, the first secondary coil of the apparatus quenches 31. In general, this leads to a deterioration of the coverage resp. compensation of the primary magnetic flux, what leads to a sudden increase of the effective inductance (resp. AC resistance) by ΔZ. In turn, this increase of inductance leads to a sudden drop of the primary current, since it becomes harder for the AC current to flow through the primary coil. Note that this means that the consumers of the consumer network will obtain less current (or power) then, what is a desired effect of the protection concept.

If after the first quench the primary current increases further, e.g. due to more parallel consumers, the effective inductance Z stays constant for some time, see intermediate phase 32, until the next secondary coil quenches 33. Again, this leads to a sudden increase in Z, and to a sudden drop in i. This behavior continues analogously until the last secondary coil quenches 34 at primary current IP2. After that, further increase in the primary current I will not change the effective inductance at Z2 any more, see final phase 35. Inductance Z2 basically corresponds to an "empty" primary coil, i.e. to a state without any secondary coils.

In the course of an inventive current conditioning by an inventive apparatus, there are typically at least 10 secondary coils, and preferably at least 30 secondary coils, that quench subsequently and lead to a smooth effective inductance characteristic (note that in Fig. 12, for simplification, only five quenches or respective steps are shown in the diagram, for simplification).

In the example shown, over the sequence of quenches, the effective inductance Z increases from Z1 to Z2, which is about 5*Z1. That means that Z2-Z1 is here about 4*Z1. In general, Z2-Z1 ≥0.8*Z1 is preferred. Please note that Z1 may be very small if the coverage of the primary flux is high, so also Z2-Z1≥10*Z1 often applies.

Further, in the example shown, IP2 is here about 1.5*IP1. This means that the difference IP2-IP1 is here about 0.5*IP1. In general IP2-IP1≥0.3*IP1 is preferred. Please note that in general it is often desired that the primary current i is limited over a significant range, so also
IP2-IP1≥2.0*IP1 often applies.

Note that an inventive apparatus can also be used for reducing a current noise in a primary current, i.e. to filter out the current noise, so a smoother primary current can be obtained. For this purpose, the apparatus may be operated with an average current at which a part, i.e. neither all nor none, of the secondary coils have quenched. In other words, the apparatus is operated in a middle part 36 on the ascending part of the curve of Fig. 12 (note that in practice, with enough secondary coils, the curve will be practically smooth). If the primary current i fluctuates up (or down), the effective inductance Z will also go up (or down), what will mitigate (dampen) the primary current fluctuations.

**Fig. 13** illustrates in cross-section a piece of electrically insulating material 5 for use in an inventive apparatus, here a plate 4 of insulating material 5 (compare e.g. Fig. 1). The insulating material 5 comprises two dielectric (electrically insulating) material layers 40a, 40b, for example made of a ceramic, and a metallic (or more generally electrically conducting) material layer 41 sandwiched between the dielectric material layers 40a, 40b. The metallic material layer 41 is typically made of a good conductor such as copper, and is much thinner than each dielectric material layer 40a, 40b (such as by factor of 20 or more). The metallic material layer 41 helps to homogenize electric fields at the insulating material 5, and thus impedes voltage breakthroughs. In the example shown, the edges of the metallic material layer 41 are recessed as compared to the edges of the dielectric material layers 40a, 40b, and electrically insulating plug elements 42 protect the edges of the metallic material layer 41.

### List of reference signs

- 1: apparatus
- 2: primary coil
- 2a, 2b: parts of the primary coil
- 3, 3a-3l: secondary coil
- 4: plate
- 5: insulating material
- 6a, 6b: subcoil
- 7: circle
- 8a, 8b: further secondary coil
- 9a, 9b: next secondary coil
- 10: support
- 11: jacket tube
- 12: bent plate
- 13, 13a-13e: compartment
- 14: secondary side
- 14a, 14b: part of secondary side
- 15a, 15b: yoke
- 16a, 16b: cryocontainer
- 17a, 17b: connections
- 18: direction of primary magnetic flux
- 19a-19c: substructures
- 20: primary magnetic flux
- 21a, 21b: part of primary magnetic flux
- 22: portion of primary magnetic flux
- 22a, 22b: subportion / identical part
- 23: further portion of primary magnetic flux
- 23a: subportion
- 30: early phase
- 31: first quench
- 32: intermediate phase
- 33: next quench
- 34: last quench
- 35: final phase
- 36: middle part
- 40a, 40b: dielectric material layer
- 41: metallic material layer
- 42: electrically insulating plug element
- 50: torus
- A: axis
- L1-L6: layers of secondary coils
- i: primary current
- IP1: primary current when first quench starts
- IP2: primary current when last quench starts
- R: rotation
- Z: effective inductance
- Z1: effective inductance before first quench
- Z2: effective inductance after last quench

## Claims

1. An apparatus (1) for current conditioning, comprising
- a primary coil (2) of electrically conducting material, and
- a plurality of secondary coils (3, 3a-3l) of superconductor material, with the secondary coils (3, 3a-3l) inductively coupled to the primary coil (2), wherein at least a part of the secondary coils (3, 3a-3l) are arranged laterally shifted to each other with respect to a direction (18) of a primary magnetic flux (20) of the primary coil (2),
**characterized in**
**that** at least a part of the secondary coils (3, 3a-3l) are arranged axially shifted to each other with respect to a direction (18) of a primary magnetic flux (20) of the primary coil (2),
and **that** at least for said part of the secondary coils (3, 3a-3l) that are laterally shifted to each other, electrically insulating material (5) is provided between the secondary coils (3, 3a-3l).

2. An apparatus (1) according to claim 1, **characterized in**
**that** the secondary coils (3, 3a-3l) are arranged in a plurality of layers (L1-L6) which are subsequent along the direction (18) of the primary magnetic flux (20) of the primary coil (2), with each layer (L1-L6) comprising a plurality of the secondary coils (3, 3a-3l),
and **that** in at least one of the layers (L1-L6), at least some of the secondary coils (3, 3a-3l) each overlap with at least two further secondary coils (8a, 8b) arranged in another layer (L1-L6) or other layers (L1-L6) than the layer (L1-L6) of the respective secondary coil (3, 3a-3l), wherein a part of each of the at least two further secondary coils (8a, 8b) does not overlap with the respective secondary coil (3, 3a-3l).

3. An apparatus (1) according to claim 2, **characterized in**
**that** said part of at least one of the further secondary coils (8a, 8b) overlaps with at least one next secondary coil (9a, 9b) in another layer (L1-L6) than the layer (L1-L6) of the respective further secondary coil (8a, 8b),
and **that** a part of the next secondary coil (9a, 9b) neither overlaps with the further secondary coil (8a, 8b), nor with the respective secondary coil (3, 3a-3l).

4. An apparatus (1) according to one of the claims 2 or 3, **characterized in**
**that** for at least some of the secondary coils (3, 3a-3l), at least 5%, preferably at least 10%, of the inner cross-sectional area of a respective secondary coil (3, 3a-3l) does not overlap with any other secondary coils (3, 3a-3l).

5. An apparatus (1) according to one of the claims 2 through 4,
**characterized in that** in a number of N layers (L1-L6), with N a natural number ≥2,
- at least some of the secondary coils (3, 3a-3l) of a respective layer (L1-L6) are periodically arranged in a circumferential direction, with an angle period AP,
- and the angular positions of at least some of the secondary coils (3, 3a-31) are shifted between the layers (L1-L6) in steps of an angle AP/N.

6. An apparatus (1) according to one of the preceding claims, **characterized in that** the entirety of secondary coils (3, 3a-3l) is designed such that it interacts with at least 50%, preferably at least 80%, most preferably at least 90% of the primary magnetic flux (20) in a quenched state of the secondary coils (3, 3a-3l).

7. An apparatus (1) according to one of the preceding claims, **characterized in that** at least some of the secondary coils (3, 3a-3l), and preferably all secondary coils (3, 3a-3l), are of closed loop type.

8. An apparatus (1) according to one of the preceding claims, **characterized in that** at least some of the secondary coils (3, 3a-3l) have a non-circular cross-section, in particular a basically sector-shaped cross-section.

9. An apparatus (1) according to one of the preceding claims, **characterized in that** at least some secondary coils (3, 3a-3l) exhibit different critical currents.

10. An apparatus (1) according to one of the preceding claims, **characterized in that** at least some of the secondary coils (3, 3a-3l) comprise a plurality of nested closed loop type subcoils (6a, 6b) each.

11. An apparatus (1) according to one of the claims 1 through 10,
**characterized in that** the secondary coils (3, 3a-3l) are arranged radially within the primary coil (2).

12. An apparatus (1) according to one of the claims 1 through 10,
**characterized in that** at least some of the secondary coils (3, 3a-3l) are arranged shifted away from the primary coil (2) along a direction (18) of the primary magnetic flux (20) of the primary coil (2), in particular wherein the secondary coils (3, 3a-3l) are arranged on a torus (50).

13. An apparatus (1) according to one of the preceding claims, **characterized**
**in that** the secondary coils (3, 3a-3l) are arranged in a plurality of layers (L1-L6) which are subsequent along the direction (18) of the primary magnetic flux (20) of the primary coil (2), with each layer (L1-L6) comprising a plurality of the secondary coils (3, 3a-3l),
and that the apparatus (1) further comprises a cryostat arrangement with a plurality of separate cryocontainers (16a, 16b), in particular wherein each cryocontainer (16a-16b) is filled with a cryogen such as liquid helium, and wherein each cryocontainer (16a-16b) contains at least one layer (L1-L6) of secondary coils (3, 3a-3l), in particular wherein the separate cryocontainers (16a, 16b) are arranged in separate vacuum containers.

14. A method for current conditioning,
wherein a primary current (i) to be conditioned is transported in a primary coil (2) of electrically conducting material,
and wherein a primary magnetic flux (20) of the primary coil (2) interacts with a plurality of secondary coils (3, 3a-3l) of superconductor material and induces secondary currents in the secondary coils (3, 3a-3l),
wherein at least for a part of the secondary coils (3, 3a-3l), the secondary coils (3, 3a-3l) interact with different parts (21a, 21b) of the primary magnetic flux (20) each,
in particular wherein the primary coil (2) and the secondary coils (3, 3a-31) belong to an apparatus (1) according to one of the claims 1 through 13,
**characterized in**
**that** at least for a part of the secondary coils (3, 3a-3l), the secondary coils (3, 3a-3l) interact with identical parts (22a, 22b) of the primary magnetic flux (20) at different axial positions along the direction (18) of the primary magnetic flux (20) each,
**that** at least for said part of the secondary coils (3, 3a-3l) interacting with different parts (21a, 21b) of the primary magnetic flux (20), a voltage breakthrough between the secondary coils (3, 3a-3l) is prevented by arranging an insulation material (5) between these secondary coils (3, 3a-3l),
and **that** the primary current (i) is conditioned by subsequent quenching and/or resuming superconductivity of secondary coils (3, 3a-3l) or groups of secondary coils (3, 3a-3l) when the primary current (i) changes.

15. A method according to claim 14, **characterized in**
**that** the secondary coils (3, 3a-3l) are chosen and arranged such that for a plurality of portions (22) of the primary magnetic flux (20), each portion (22)
- fully interacts with at least one secondary coil (3, 3a-3l),
- and interacts, in particular partially interacts, with at least two further secondary coils (8a, 8b),
wherein each of the further secondary coils (8a, 8b) interacts, in particular partially interacts, also with at least one further portion (23) of the primary magnetic flux (20) which does not interact with the respective secondary coil (3, 3a-3l).

16. Method according to one of one of the claims 14 or 15, **characterized in**
**that** the secondary coils (3, 3a-3l) are chosen and arranged such that a desired characteristic of an increase of an effective impedance (Z) of the primary coil (2) is achieved when the primary current (i) is increased,
in particular wherein the following applies:
IP2-IP1 ≥ 0.3*IP1, preferably IP2-IP1 ≥ 0.5*IP1,
and/or Z2-Z1 ≥ 0.8*Z1, preferably Z2-Z1 ≥ 1.5*Z1,
with IP1: primary current (i) when a first secondary coil (3, 3a-3l) quenches (31), IP2: primary current (i) when a last secondary coil (3, 3a-31) quenches (34), Z1: effective impedance (Z) of the primary coil (2) before the first secondary coil (3, 3a-3l) quenches (31), Z2: effective impedance (Z) of the primary coil (2) after the last secondary coil (3, 3a-31) quenches (34).

## Amended claims

### Amended claims in accordance with Rule 137(2) EPC.

1. An apparatus (1) for current conditioning, comprising
- a primary coil (2) of electrically conducting material, and
- a plurality of secondary coils (3, 3a-3l) of superconductor material, with the secondary coils (3, 3a-3l) inductively coupled to the primary coil (2), wherein at least a part of the secondary coils (3, 3a-3l) are arranged laterally shifted to each other with respect to a direction (18) of a primary magnetic flux (20) generated by the primary coil (2) such that they interact with, i.e. have running through it, different parts (21a, 21b) of the primary magnetic flux (20) each,
wherein the direction of the primary magnetic flux (20) is determined by its core where the flux density has maxima,
**characterized in**
**that** at least a part of the secondary coils (3, 3a-3l) are arranged axially shifted to each other with respect to a direction (18) of a primary magnetic flux (20) of the primary coil (2) such that they interact with, i.e. have running through it, identical parts (22a, 22b) of the primary magnetic flux (20) each,
**that** at least for said part of the secondary coils (3, 3a-3l) that are laterally shifted to each other, electrically insulating material (5) is provided between the secondary coils (3, 3a-3l)),
**that** the secondary coils (3, 3a-3l) are arranged in a plurality of layers (L1-L6) which are subsequent along the direction (18) of the primary magnetic flux (20) of the primary coil (2), with each layer (L1-L6) comprising a plurality of the secondary coils (3, 3a-3l), wherein the secondary coils (3, 3a-3l) within a layer (L1-L6) are arranged next to each other such that the secondary coils (3, 3a-3l) within the same layer (L1-L6) interact with, i.e. have running through it, different parts (22a, 22b) of the primary magnetic flux (20),
and **that** in at least one of the layers (L1-L6), at least some of the secondary coils (3, 3a-3l) each overlap with respect to the direction (18) of a primary magnetic flux (20) with at least two further secondary coils (8a, 8b) arranged in another layer (L1-L6) or other layers (L1-L6) than the layer (L1-L6) of the respective secondary coil (3, 3a-3l), wherein a part of each of the at least two further secondary coils (8a, 8b) does not overlap with the respective secondary coil (3, 3a-3l).

2. An apparatus (1) according to claim 1, **characterized in**
**that** said part of at least one of the further secondary coils (8a, 8b) overlaps with at least one next secondary coil (9a, 9b) in another layer (L1-L6) than the layer (L1-L6) of the respective further secondary coil (8a, 8b),
and **that** a part of the next secondary coil (9a, 9b) neither overlaps with the further secondary coil (8a, 8b), nor with the respective secondary coil (3, 3a-3l).

3. An apparatus according to claim 2, **characterized in that** the next secondary coil (9a, 9b) is arranged in the same layer (L1-L6) as the respective secondary coil (3, 3a-3l).

4. An apparatus (1) according to one of the preceding claims, **characterized in that** for at least some of the secondary coils (3, 3a-3l), at least 5%, preferably at least 10%, of the inner cross-sectional area of a respective secondary coil (3, 3a-3l) does not overlap with any other secondary coils (3, 3a-3l).

5. An apparatus (1) according to one of the preceding claims, **characterized in that** in a number of N layers (L1-L6), with N a natural number ≥2,
- at least some of the secondary coils (3, 3a-3l) of a respective layer (L1-L6) are periodically arranged in a circumferential direction, with an angle period AP,
- and the angular positions of at least some of the secondary coils (3, 3a-3l) are shifted between the layers (L1-L6) in steps of an angle AP/N.

6. An apparatus (1) according to one of the preceding claims, **characterized in that** the entirety of secondary coils (3, 3a-3l) is designed such that it interacts with, i.e. has running through it, at least 50%, preferably at least 80%, most preferably at least 90% of the primary magnetic flux (20) in a quenched state of the secondary coils (3, 3a-3l).

7. An apparatus (1) according to one of the preceding claims, **characterized in that** at least some of the secondary coils (3, 3a-3l), and preferably all secondary coils (3, 3a-3l), are of closed loop type.

8. An apparatus (1) according to one of the preceding claims, **characterized in that** at least some of the secondary coils (3, 3a-3l) have a non-circular cross-section, in particular a basically sector-shaped cross-section.

9. An apparatus (1) according to one of the preceding claims, **characterized in that** at least some secondary coils (3, 3a-3l) exhibit different critical currents.

10. An apparatus (1) according to one of the preceding claims, **characterized in that** at least some of the secondary coils (3, 3a-3l) comprise a plurality of nested closed loop type subcoils (6a, 6b) each.

11. An apparatus (1) according to one of the claims 1 through 10, **characterized in that** the secondary coils (3, 3a-3l) are arranged radially within the primary coil (2).

12. An apparatus (1) according to one of the claims 1 through 10, **characterized in that** at least some of the secondary coils (3, 3a-3l) are arranged shifted away from the primary coil (2) along a direction (18) of the primary magnetic flux (20) of the primary coil (2), in particular wherein the secondary coils (3, 3a-3l) are arranged on a torus (50).

13. An apparatus (1) according to one of the preceding claims, **characterized in that** the secondary coils (3, 3a-3l) are arranged in a plurality of layers (L1-L6) which are subsequent along the direction (18) of the primary magnetic flux (20) of the primary coil (2), with each layer (L1-L6) comprising a plurality of the secondary coils (3, 3a-3l),
and that the apparatus (1) further comprises a cryostat arrangement with a plurality of separate cryocontainers (16a, 16b), in particular wherein each cryocontainer (16a-16b) is filled with a cryogen such as liquid helium, and wherein each cryocontainer (16a-16b) contains at least one layer (L1-L6) of secondary coils (3, 3a-3l), in particular wherein the separate cryocontainers (16a, 16b) are arranged in separate vacuum containers.

14. A method for current conditioning,
wherein a primary current (i) to be conditioned is transported in a primary coil (2) of electrically conducting material,
and wherein a primary magnetic flux (20) generated by the primary coil (2) interacts with a plurality of secondary coils (3, 3a-3l) of superconductor material and induces secondary currents in the secondary coils (3, 3a-3l),
wherein at least for a part of the secondary coils (3, 3a-3l), the secondary coils (3, 3a-3l) interact with different parts (21a, 21b) of the primary magnetic flux (20) at different lateral positions with respect to a direction (18) of the primary magnetic flux (20) each,
wherein the direction (18) of the primary magnetic flux (20) is determined by its core where the flux density has maxima,
in particular wherein the primary coil (2) and the secondary coils (3, 3a-3l) belong to an apparatus (1) according to one of the claims 1 through 13,
**characterized in**
**that** at least for a part of the secondary coils (3, 3a-3l), the secondary coils (3, 3a-3l) interact with identical parts (22a, 22b) of the primary magnetic flux (20) at different axial positions along the direction (18) of the primary magnetic flux (20) each,
**that** at least for said part of the secondary coils (3, 3a-3l) interacting with different parts (21a, 21b) of the primary magnetic flux (20), a voltage breakthrough between the secondary coils (3, 3a-3l) is prevented by arranging an insulation material (5) between these secondary coils (3, 3a-3l),
**that** the primary current (i) is conditioned by subsequent quenching and/or resuming superconductivity of the secondary coils (3, 3a-3l) or groups of the secondary coils (3, 3a-3l) when the primary current (i) changes,
**that** the secondary coils (3, 3a-3l) are chosen and arranged such that for a plurality of portions (22) of the primary magnetic flux (20), each portion (22)
- fully interacts with at least one secondary coil (3, 3a-3l),
- and interacts, in particular partially interacts, at a different axial position along the direction (18) of the primary magnetic flux (20) with at least two further secondary coils (8a, 8b),
wherein each of the further secondary coils (8a, 8b) interacts, in particular partially interacts, also with at least one further portion (23) of the primary magnetic flux (20) which does not interact with the respective secondary coil (3, 3a-3l).

15. A method according to claim 14, **characterized in that** said at least one further portion (23) of the primary magnetic flux (20) which does not interact with the respective secondary coil (3; 3a-3l) interacts with at least one next secondary coil (9a, 9b) which is arranged in the same axial position as the respective secondary coil (3, 3a-3l).

16. Method according to one of one of the claims 14 or 15, **characterized in that** the secondary coils (3, 3a-3l) are chosen and arranged such that a desired characteristic of an increase of an effective impedance (Z) of the primary coil (2) is achieved when the primary current (i) is increased,
in particular wherein the following applies:
IP2-IP1 ≥ 0.3*IP1, preferably IP2-IP1 ≥ 0.5*IP1,
and/or Z2-Z1 ≥ 0.8*Z1, preferably Z2-Z1 ≥ 1.5*Z1,
with IP1: primary current (i) when a first secondary coil (3, 3a-3l) quenches (31), IP2: primary current (i) when a last secondary coil (3, 3a-3l) quenches (34), Z1: effective impedance (Z) of the primary coil (2) before the first secondary coil (3, 3a-3l) quenches (31), Z2: effective impedance (Z) of the primary coil (2) after the last secondary coil (3, 3a-3l) quenches (34).
